## Europäisches Patentamt
## European Patent Office
## Office européen des brevets

(19)

(11) Veröffentlichungsnummer: **0 075 767**
**B1**

(12) # EUROPÄISCHE PATENTSCHRIFT

(45) Veröffentlichungstag der Patentschrift:
02.09.87

(21) Anmeldenummer: **82108382.1**

(22) Anmeldetag: **11.09.82**

(51) Int. Cl.⁴: **G 01 N 21/27, G 01 J 1/44,
G 06 G 7/186**

(54) **Verfahren zum Erfassen und Auswerten photometrischer Signale und Anordnung zur Durchführung des Verfahrens.**

(30) Priorität: **30.09.81  DE 3138879**

(43) Veröffentlichungstag der Anmeldung:
**06.04.83 Patentblatt 83/14**

(45) Bekanntmachung des Hinweises auf die Patenterteilung:
**02.09.87 Patentblatt 87/36**

(84) Benannte Vertragsstaaten:
**AT BE CH DE FR GB IT LI LU NL SE**

(56) Entgegenhaltungen:
**EP-A-0 022 524
DD-A-140 290
DE-A-2 158 057
DE-B-2 814 358
US-A-4 061 925**

**ELEKTRONIK, Nr. 12, 1975 G. STARK "Fotometer für die Absorptionsmessung im Durchlicht" Seiten 65 bis 68**

(73) Patentinhaber: **BOEHRINGER MANNHEIM GMBH,
Patentabteilung, Abt. E Sandhofer Strasse 112-132 Postfach 31 01 20, D-6800 Mannheim 31 Waldhof (DE)**

(72) Erfinder: **Rösicke, Bernd, Wormserstrasse 35,
D-6800 Mannheim 31 (DE)**
Erfinder: **Von Rosenbladt, Rudolf,
Ferdinandstrasse 7, D-6380 Bad Homburg 1 (DE)**

EP 0 075 767 B1

## Beschreibung

Die Erfindung betrifft ein Verfahren nach dem Oberbegriff des Anspruchs 1.

Weiter richtet sich die Erfindung auf eine Anordnung zur Durchführung des Verfahrens.

Verfahren zur Erfassung photometrischer Signale gelangen zum Zwecke von analytischen Bestimmungen, insbesondere für medizinische Zwecke, in zunehmendem Maße zur Anwendung, wobei häufig Teststreifen eingesetzt werden. Bei derartigen Teststreifen erfolgen auf den Testfeldern chemische Reaktionen zwischen Inhaltsstoffen der Körperflüssigkeit (z. B. Urin, Blut) und auf dem Testfeld vorhandenen Reagenzien, wobei eine Farbveränderung des Testfeldes eintritt. Diese Farbveränderung kann mittels geeigneter Verfahren bzw. entsprechender Geräte quantitativ ausgewertet werden. So kann beispielsweise mittels eines Reflexionsphotometers der Reflexionsgrad der Testfeldoberfläche nach Ablauf der Reaktion bei einer oder mehreren Wellenlängen bestimmt werden. Außer dem einen Meßwert wird häufig ein Referenzwert und gegebenenfalls ein oder mehrere weitere Meßwerte je nach den gegebenen Verhältnissen ausgewertet. Daneben spielen nach wie vor in der klinischen Chemie analytische Bestimmungen eine große Rolle, bei denen eine Farbreaktion in einer Flüssigkeit mit einem Durchlichtphotometer ausgewertet wird. Auch auf diese Photometer richtet sich die vorliegende Erfindung.

Die Erfindung wird am Beispiel eines Reflexionsphotometers beschrieben, auf das sie sich bevorzugt richtet. Dieses hat eine Ulbricht'sche Kugel, mittels welcher das Licht einer Lichtquelle gleichmäßig verteilt wird, so daß der Teststreifen über eine Meßöffnung mit diffusem Licht beleuchtet wird. In dieser Kugel sind ferner zwei Photoempfänger derart angeordnet, daß der eine Empfänger als Meßempfänger nur Licht vom Testfeld und der andere Empfänger als Referenzempfänger nur Licht von einem ungestörten Teil der inneren Kugeloberfläche erhält. Die photometrischen Signale werden durch die bevorzugt als Photodioden ausgebildeten Empfänger in sehr geringe Ströme in der Größenordnung von 1 nA umgewandelt und die derart erhaltenen Meßwerte müssen nachfolgend verstärkt und ausgewertet werden.

Insbesondere in der klinischen Chemie werden an die Erfassung und Auswertung der photometrischen Signale außerordentlich hohe Anforderungen gestellt. Um die geringen Ströme mit einer hinreichenden Auflösung zu messen, müssen noch Schwankungen von 1 pA zuverlässig registriert werden. Dieser Zielsetzung stehen eine Vielzahl von Störquellen gegenüber. Dies sind einerseits die für eine Auswerteelektronik zum Nachweis sehr kleiner Signale bekannten Probleme wie Verstärkerdrift, überlagerte Gleichspannungen (insbesondere Offsetspannungen der Bauteile), relativ hochfrequente Rauschspannungen, niederfrequente Wechselspannungen, insbesondere Brummspannungen, die mit Netzfrequenz eingestreut werden, Eingangsströme von Verstärkern und Kriech- oder Restströme verschiedener Art.

Hinzu kommen für eine optische Messung typische Störquellen, insbesondere durch Fremd- oder Störlicht. Auch hier beobachtet man vergleichsweise konstante Gleichspannungsanteile neben typischen Störungen durch netzbetriebene Fremdlichtquellen, die mit der üblichen Netzfrequenz von 50 Hz oder 60 Hz arbeiten.

Um diese Störquellen zu unterdrücken, wurden bereits eine Vielzahl von Vorschlägen gemacht. Insbesondere ist es weit verbreitet, die Lichtquelle in Hellphasen und Dunkelphasen zu takten, indem man sie entweder ein- und ausschaltet oder durch eine geeignete Blende periodisch abdeckt. Die Empfängersignale werden dann sowohl während eines Teils der Hellphase als auch während eines Teils der Dunkelphase in gleicher Weise ausgewertet. Durch Subtraktion des Ergebnisses während der Dunkelphase von dem während der Hellphase erhaltenen Ergebnis können solche Störungen weitgehend eliminiert werden, die additive Beiträge zum Meßsignal liefern und sich im Verhältnis zur Taktfrequenz der Lichtquelle langsam ändern.

Zur Unterdrückung hochfrequenter Störungen sind Verfahren geeignet, bei denen das Signal des Meßempfängers über eine gewisse Zeit integriert wird. Dadurch werden hochfrequente Störungen mit Frequenzen, die viel größer sind als die reziproke Integrationszeit, weitgehend unterdrückt.

Aus der deutschen Auslegeschrift 28 14 358 ist ein Verfahren der eingangs bezeichneten Art und eine entsprechende Vorrichtung bekannt, in der diese beiden Maßnahmen kombiniert werden. Dabei wird ein Empfänger von der getakteten Lichtquelle beleuchtet und die Signale werden sowohl während eines Teils der Hellphase als auch während eines Teils der Dunkelphase integriert. Unmittelbar nach der jeweiligen Integration werden die Integrationswerte digitalisiert. Zu diesem Zweck wird eine konstante Vergleichsspannung an den zur Integration verwedeten Integrator angelegt, und nach dem Muster eines Analog/Digital-Wandlers nach dem Doppelintegrationsprinzip wird mit der konstanten Vergleichsspannung abintegriert, während gleichzeitig ein Zählvorgang ausgelöst wird. Die Ausgangsspannung des Integrators wird dabei mittels eines Komparators mit einem Null-Potential, verglichen und der Zählvorgang wird unterbrochen, sobald der Ausgang des Integrators das Null-Potential erreicht hat. Bei dem bekannten Verfahren wird auf diese Weise sowohl des Empfängersignal während der Hellphase als auch dasjenige während der Dunkelphase ausgewertet und die beiden digitalisierten Ergebnisse werden danach voneinander subtrahiert, um einen korrigierten Meßwert zu erhalten.

Obwohl auf diese Weise, wie erwähnt, sowohl hochfrequente Störungen als auch ein Teil der niederfrequenten Störungen eliminiert werden, kann das bekannte Verfahren noch nicht befriedigen. Ein wesentlicher Punkt dabei ist, daß eine zufriedenstellende Genauigkeit nur mit einem verhältnismäßig großen schaltungstechnischen Aufwand erreicht werden kann. Um nämlich auch verhältnismäßig hochfrequente Schwankungen des Signals mit Hilfe der Hell-Dunkel-Taktung der Lichtquelle unterdrücken zu können, muß die Taktung mit einer verhältnismäßig hohen Frequenz erfolgen. Dadurch wird die Integrationszeit während der Hellphase einerseits und während der Dunkelphase andererseits vergleichsweise gering. Die Auflösung des Analog/Digital-Wandlers nach dem Doppelintegrationsverfahren ist aber bei gegebener Zählerfrequenz und Schaltgeschwindigkeit der Bauteile wesentlich durch die zur Verfügung stehende maximale Abintegrationszeit bestimmt. Ist diese sehr kurz, so bleibt nur die Möglichkeit, entsprechend schnelle Bauteile zu verwenden, wodurch die Kosten der Anordnung ungünstig beeinflußt werden.

Aufgabe der vorliegenden Erfindung ist es daher, ein Verfahren der eingangs genannten Art anzugeben, bei welchem in einfacher Weise und mit geringem baulichem Aufwand Meßfehler der erwähnten Art unterdrückt werden, so daß eine hohe Auflösung und Genauigkeit erreicht wird. Dabei sollen aufwendige Abgleichmaßnahmen, die in der Regel besondere Fachkenntnisse und Sorgfalt erfordern, vermieden werden, um die Kosten der Herstellung und Wartung der nach dem erfindungsgemäßen Verfahren arbeitenden Geräte niedrig zu halten.

Diese Aufgabe wird durch ein Verfahren gemäß den Ansprüchen 1 - 5 und eine Anordnung gemäß den Ansprüchen 6 - 9 gelöst.

Die Integration kann praktisch während der ganzen Hellphase einerseits und der ganzen Dunkelphase andererseits durchgeführt werden, bevorzugt wird jedoch während des ersten Teils sowohl der Hellphase als auch der Dunkelphase der Meßwert des Empfängers während einer Verzögerungszeit nicht integriert. Zu Beginn der Hellphase schwingt nämlich, insbesondere infolge von Erwärmungsvorgängen in der Lichtquelle, welche insbesondere als ein LED-Chip ausgebildet ist, der Meßwert bzw. die Ausgangsspannung an dem Empfänger über. Ferner bewirken Relaxationseffekte in den bevorzugt als Photodioden ausgebildeten Empfängern zu Beginn der Dunkelphase ein verzögertes Absenken des Meßwertes. Diese temperaturabhängigen und quantitativ schwer erfaßbaren Effekte werden während der genannten Verzögerungszeiten nicht integriert und sozusagen ausgeblendet. Darüber hinaus werden aber auch sonstige Einschwingvorgänge ausgeblendet.

Aufgrund der Integration während mehrerer aufeinander folgender Hell- und Dunkelphasen ohne zwischen zeitliche Digitalisierung ist es möglich, eine lange Integrationszeit zu realisieren und dennoch mit einer relativ hohen Taktfrequenz der Lichtquelle zu arbeiten. Dadurch werden einerseits wegen der langen Integrationszeit noch relativ niederfrequente Hochfrequenzstörungen und andererseits wegen der relativ hohen Taktfrequenz auch sich relativ schnell ändernde Gleichspannungsanteile zuverlässig eliminiert. Da die Digitalisierung erst nach mehreren Integrationen notwendig ist, kann auch die Digitalisierungszeit relativ lang gewählt und somit mit kostengünstigen Bauteilen eine hohe Auflösung erreicht werden. Diese Vorteile werden mit äußerst einfachen Mitteln und damit zu sehr geringen Kosten erzielt.

Die Integrationszeit ist bei gegebener Taktfrequenz der Lichtquelle und damit Dauer der Meßspannungsperiode von der Zahl der Meßspannungsperioden abhängig, die zur Integration herangezogen werden. Diese ist bevorzugt größer als 1 und nach oben im wesentlichen nur durch die maximale Zeit limitiert, die für einen Meßvorgang zur Verfügung steht.

Um auch die mit der Netzfrequenz (üblicherweise 50 Hz oder 60 Hz) synchronen Störungen zuverlässig unterdrücken zu können, wird die Periodendauer der Meßspannungsperiode bevorzugt so gewählt, daß sie ein geradzahliges Vielfaches des Periodendauer der Netzfrequenz ist. Dadurch wird erreicht, daß die mit der Netzfrequenz synchronen Störungen jeweils in gleicher Weise in der Hellphase und in der Dunkelphase auftreten, so daß sie eliminiert werden, wenn erfindungsgemäß der Meßwert des Empfängers während eines Teils der Hellphase mit umgekehrtem Vorzeichen wie während des entsprechenden Teils der Dunkelphase an dem Integrator anliegt.

Allgemein können beliebige Teile der Hellphase und der Dunkelphase erfindungsgemäß zur Integration verwendet werden, wichtig ist lediglich, daß sie gleich groß sind, damit die Korrekturgröße der Meßgröße entspricht.

Besonders bevorzugt kommt bei dem erfindungsgemäßen Verfahren neben dem aus Lichtquelle, Meßobjekt und Meßempfänger bestehenden Meßkanal ein Referenzkanal zur Anwendung, der, bevorzugt ausgehend von der gleichen Lichtquelle, ein Referenzobjekt und einen Referenzempfänger einschließt. Bevorzugt ist hierzu in der Integrationskugel eines Reflexionsphotometers eine zweite Photodiode vorgesehen. Die Erfindung ist hierauf jedoch nicht beschränkt und schließt auch Fälle ein, bei denen der gleiche Empfänger als Referenzempfänger und Meßempfänger benutzt wird. Die erfindungsgemäßen Vorteile werden besonders gut genutzt, wenn bei Verwendung eines Referenzkanals das Signal des Referenzempfängers durch Umschalten alternierend mit dem Signal des Meßempfängers mit Hilfe der gleichen Meß- und Integrationsschaltung ausgewertet wird, wobei eine Integrations- und Digitalisierungsphase bei der Auswertung des Signals des Referenzempfängers vollständig einer Integrations- und Digitalisierungsphase bei der Auswertung des Signals des Meßempfängers entspricht und das Meßergebnis aus den digitalisierten Gesamtintegrationswerten durch Quotientenbildung abgeleitet wird. Dabei ist hervorzuheben, daß die Umschaltung von Referenzempfänger und Meßempfänger sowohl elektrisch erfolgen kann, was insbesondere bei Verwendung zweier getrennter Empfänger in Frage kommt, als auch als optische Umschaltung realisiert werden kann, indem mit optischen Mitteln (Spiegel, Lichtleiter u.dgl.) abwechselnd das Licht des Referenzkanals und des Meßkanals auf den bevorzugt einen Photoempfänger geleitet wird, der sowohl als Referenzempfänger als auch als Meßempfänger dient. Durch diese bevorzugte Maßnahme werden alle diejenigen Fehlerquellen beseitigt, die sich langsam im Vergleich zur Umschaltung zwischen Referenzkanal und Meßkanal ändern und einen linearen Fehlerbeitrag liefern. Zu nennen sind hier insbesondere langfristige Änderungen der die elektronische Verstärkung bestimmenden Bauteile und langfristige Änderungen der Photoempfänger-Empfindlichkeit.

Um Null-Fehler, insbesondere aufgrund des Offsets des Integrators, zu eliminieren wird eine zusätzliche Null-Kompensation durchgeführt. Hierzu wird zusätzlich zu den bisher beschriebenen Integrations- und Digitalsierungsmeßphasen für die Signale des Meßempfängers und gegebenenfalls des Referenzempfängers eine weitere völlig gleichartige Integrations- und Digitalisierungsphase durchgeführt, die sich lediglich insoweit unterscheidet, als statt eines Empfängers ein Null-Signal an die Meß-, Integrations- und Digitalisierungsschaltung angelegt wird. Dabei erhält man einen dritten Gesamtintegrationswert, der als Null-Wert zu verwenden ist und in digitalisierter Form zur Korrektur der von den Empfängern abgeleiteten digitalisierten Gesamtintegrationswerte benutzt wird.

Die erfindungsgemäße Anordnung zur Durchführung des erfindungsgemäßen Verfahrens weist eine Lichtquelle zur Bestrahlung des zu untersuchenden Objekts, einen Meßempfänger zum Empfang der von dem Objekt auf ihn auftreffenden Strahlung und zur Bildung eines Analogsignals auf. Das Analogsignal liegt an einer Meß-, Integrations- und Digitalisierungsschaltung an und schließt einen Integrator ein, um das Analogsignal des Empfängers in der zuvor beschriebenen Weise zu messen, zu integrieren und zu digitalisieren. Die Lichtquelle hat eine Unterbrechungseinrichtung, durch die sie periodisch getaktet wird, wobei in den Empfängern die Meßspannungsperiode erzeugt wird. Zum Zwecke der Digitalisierung des integrierten Signals ist ein Abintegrationsschalter vorgesehen, durch den eine einer entsprechenden Spannungsquelle entnommene Konstantspannung an den Integrator angelegt werden kann, deren Polarität dem Analogsignal des Meßempfängers entgegengesetzt ist. Wie bei Digitalisierunsschaltungen nach dem Doppelintegrationsprinzip üblich, ist weiter ein Komparator vorgesehen, um die Ausgangsspannung des Integrators mit einer Vergleichsspannung zu vergleichen. Das Ausgangssignal des Komparators liegt an einer Torschaltung an. Diese Torschaltung erhält außerdem ein Signal von einem geeigneten anderen Bauteil in dem Moment, in dem die Abintegrationsspannung an den Integrator angelegt wird. Aufgrund dieses Signals läßt die Torschaltung die Impulse eines Taktgebers so lange an einen Zähler durch, wie die Ausgangsspannung des Integrators größer als die Komparatorspannung ist. Wird dieser Zustand erreicht, so ist die Digitalisierung abgeschlossen.

Die weiter oben formulierten Ziele werden nun bei der er findungsgemäßen Anordnung mit einem geringen Schaltungsaufwand bei hoher Funktionssicherheit und unter Verwendung relativ weniger Standardbauteile erreicht.

Bevorzugte Ausführungsformen der erfindungsgemäßen Anordnung werden im Zusammenhang mit der Beschreibung der Figuren näher erläutert. Bei Realisierung der darin wiedergegebenen Maßnahmen ergibt sich eine Anordnung, die eine extrem hohe Meßgenauigkeit ermöglicht, ohne daß besonders ausgewählte Bauteile verwendet werden müssen. Die gesamte Schaltung arbeitet, ohne daß Abgleicharbeiten während der Fertigung oder während der späteren Wartung des Gerätes notwendig sind. Im Zusammenhang damit eribt sich eine ungewöhnlich gute Langzeitstabilität.

Weitere Vorteile und erfindungswesentliche Merkmale ergeben sich aus dem nachfolgend anhand der Zeichnung näher erläuterten Ausführungsbeispiel.

Es zeigen:

Fig. 1 ein Blockschaltbild einer Anordnung zur Durchführung des erfindungsgemäßen Verfahrens,

Fig. 2 ein Impulsdiagramm mit dem zeitlichen Verlauf des Integrationswertes I1,

Fig. 3 ein Blockschaltbild für die Analog-Digital-Wandlung der Meßwerte,

Fig. 4 ein Diagramm mit dem zeitlichen Verlauf der Integrationswerte sowie die Bildung der entsprechenden Digitalwerte während einer vollständigen Messung über drei Integrations- und Digitalisierungsphasen und

Fig. 5 das Prinzip-Schaltbild einer bevorzugten Schaltungsanordnung.

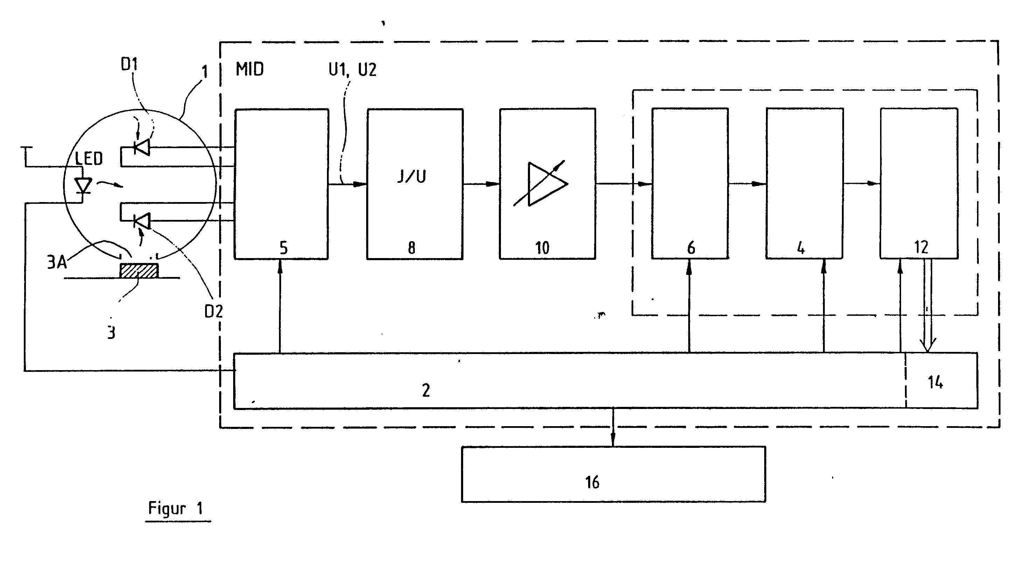

In dem Blockschaltbild gemäß Fig. 1 ist schematisch eine Ulbricht'sche Kugel mit einer Lichtquelle LED und zwei Empfängern D1, D2 dargestellt. Das Licht der LED wird bekanntlich in der Ulbricht'schen Kugel gleichmäßig verteilt, so daß das Meßobjekt, beispielsweise ein Teststreifen 3 über eine Meßöffnung 3A mit diffusem Licht beleuchtet wird. Die beiden als Dioden ausgebildeten Empfänger D1, D2 sind innerhalb der Kugel 1 derart angeordnet, daß der dem Teststreifen zugeordnete Meßempfänger D2 nur das vom Teststreifen reflektierte Licht erhält, während der Referenzempfänger D1 nur das Licht von einem ungestörten Teil der Kugelinnenfläche erhält. Die Lichtquelle LED, die Oberfläche des Teststreifens 3 und der Meßempfänger D2 bilden den Meßkanal, während die gleiche Lichtquelle LED, ein entsprechender als Referenz geeigneter Teil der Kugeloberfläche und der Referenzempfänger D1 den Referenzkanal bilden. Zur Erfassung und Auswertung der Meßwerte, welche den von den Empfängern empfangenen photometrischen Signalen entsprechen, dient eine Meß-, Integrations- und Digitalisierungsschaltung, die insgesamt mit dem Bezugszeichen MID bezeichnet ist. Sie enthält einen Umschalter 5, welcher mittels der Steuereinrichtung 2 derart betätigbar ist, daß wahlweise die Meßwerte des einen oder anderen Empfängers zu einem nachgeschalteten Wandler 8 gelangen. Mittels des Wandlers 8 werden die besagten kleinen Photoströme in entsprechende Spannungen umgewandelt, welche mittels eines nachgeschalteten Verstärkers 10 verstärkt werden. Mittels der Steuereinrichtung 2 wird außerdem die Lichtquelle LED getaktet, so daß in einer Hellphase Licht abgestrahlt wird, während in einer Dunkelphase kein Licht ausgestrahlt wird. Der Ausgang des Verstärkers 10 ist über ein Schalter-Netzwerk 6 auf einen Integrator 4 geführt. Das Schalter-Netzwerk 6 wird ebenso wie der Integrator 4 mittels der Steuereinrichtung 2 im Taktbetrieb gesteuert, wobei in drei aufeinanderfolgenden Meß-, Integrations- und Digitalisierungsphasen, welche nachfolgend noch im einzelnen zu erläutern sind, mittels des Integrators 4 die Integration der Meßwerte U1, U2 sowie der Störgrößen 01, 02 durchgeführt wird. Dem Integrator 4 ist eine Digitalisierungseinheit 12 nachgeschaltet, welche vor allem einen Komparator, ein Tor sowie einen Zähler enthält und welche nachfolgend ebenfalls im einzelnen noch erläutert wird. Es sei an dieser Stelle hervorgehoben, daß mit ein- und demselben Integrator die Mittelwertbildung der Meßwerte und die Kompensation der Störgrößen, insbesondere Offsetspannungen, und darüber hinaus auch die Analog-Digital-Wandlung und Nullpunktkompensation zusammen wirkend mit der nachgeschalteten Digitalisierungseinheit 12 durchgeführt wird, wobei die Steuerung der einzelnen Verfahrensschritte mittels der Steuereinrichtung 2 durchgeführt wird. Die in dem genannten Zähler der Digitalisierungseinheit 12 anstehenden Digitalwerte werden in eine Recheneinheit 14 der Steuereinrichtung 2 eingegeben, mittels welcher dann das Meßergebnis errechnet wird, welches über eine Anzeigevorrichtung 16 angezeigt wird.

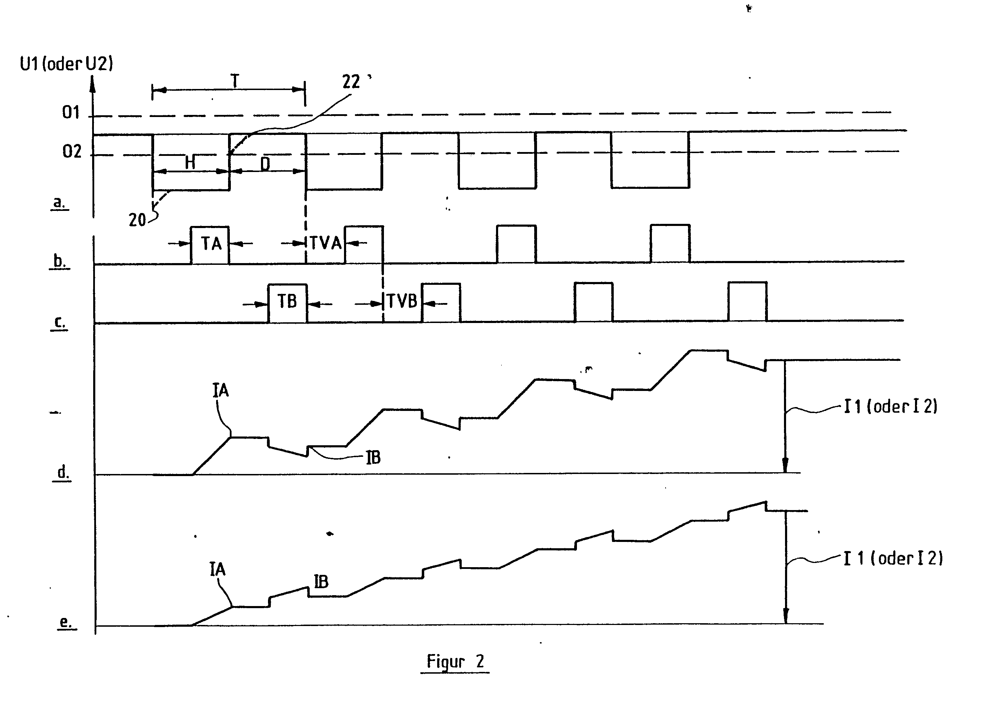

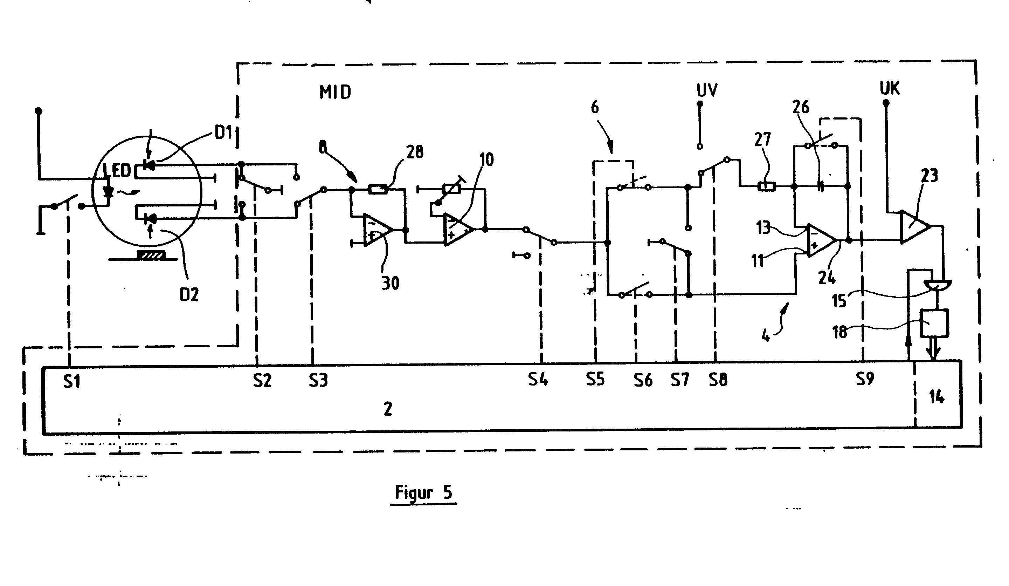

In Fig. 2 sind verschiedene Impulsdiagramme dargestellt, um den zeitlichen Verlauf des Integrationswertes I1 zu erläutern. In dem Diagramm a ist der Meß- bzw. Referenzwert U1 als eine negative Spannung dargestellt. Während einer Hellphase H steht eine entsprechende Spannung an und während der Dunkelphase D geht diese Spannung gegen Null. Die Hell- und Dunkelphasen werden durch Ein- bzw. Ausschalten der Lichtquelle LED mittels eines in Reihe geschalteten Schalters S1 bewirkt. Zur Erleichterung des Verständnisses wird auf das Prinzip-Schaltbild gemäß Fig. 5 verwiesen, aus welchem die Anordnung des genannten Schalters S1 und die nachfolgend noch beschriebenen Schalter ersichtlich ist. Die Periodendauer T für eine Hellphase H und eine Dunkelphase D beträgt zweckmäßigerweise 200 msec., so daß erfindungsgemäß auch überlagerte Wechselspannungen mit Grundfrequenzen von 50 oder 60 Hz kompensiert werden können und durch derartige Wechselspannungen bedingte Schwebungen vermieden werden. Zu Beginn der Hellphase H schwingt der Meßwert U1, wie durch die gestrichelte Linie 20 angedeutet, über. Dieses Überschwingen wird insbesondere durch den Temperaturgang der Lichtquelle LED verursacht. Zu Beginn der Dunkelphase D geht der Meßwert mit einer gewissen Verzögerung gegen Null, wie es durch die strichpunktierte Linie 22 angedeutet ist; Ursache hierfür ist die Relaxation des als Fotodiode ausgebildeten Empfängers D1. Zwecks Ausschaltung der erwähnten Vorgänge und auch sonstiger Einschalt- bzw. Ausschaltvorgänge wird daher mit der Integration erst nach Verzögerungszeiten TVA und TVB begonnen. Im Diagramm a ist ferner eine positive Offsetspannung 01, sowie eine negative Offsetspannung 02 eingetragen. Im folgenden wird erläutert, wie die Offsetspannungen in diesen beiden alternativ möglichen Fällen eliminiert werden. Ferner sind vier Perioden der mit einer Frequenz von 5 Hz getakteten Meßspannung U1 dargestellt (Meßspannungsperioden T). Das Diagramm b zeigt die Impulse, welche die Aufintegration des Meßwertes zusammen mit der positiven oder negativen Offsetspannung steuern. Die genannten Impulse beginnen nach Verzögerungszeiten TVA nach Beginn der Hellphase H, wobei eine Integrationszeit TA von 50 msec. vorgegeben wird. Während der Integrationszeit TA ist der Schalter S5 gemäß Fig. 5 geschlossen, so daß die Aufintegration durchgeführt werden kann. Das Diagramm c zeigt die Impulse während der Dunkelphase D, wobei für die Dauer der Integrationszeit TB die Abintegration durchgeführt wird. Die Impulse beginnen jeweils nach einer Verzögerungszeit TVB nach Beginn der Dunkelphase D. Es sei besonders hervorgehoben, daß die Integrationszeiten TA und TB gleich groß sind. Die Integrationszeiten dauern jeweils 50 msec.

und auch die Verzögerungszeiten TVA und TVB sind 50 msec. lang. Während jedoch die Integrationszeiten TA und TB gleich groß sein müssen, können die Verzögerungszeiten TVA und TVB in besonderen Anwendungsfällen auch voneinander und gegenüber den Integrationszeiten TA und TB verschieden gewählt werden. Da sich eine Meßspannungsperiode als Summe von Integrationszeiten TA und TB und möglicherweise jeweils mehrerer Verzögerungszeiten ergibt, ist es demzufolge auch möglich, daß die Hellphase und die Dunkelphase verschieden lang sind. Bei der hier gewählten Ausführungsform, bei der die Verzögerungszeiten TVA und TVB untereinander gleich und ebenso lang wie die Integrationszeiten TA und TB sind, und bei der demzufolge auch die Hellphase H und die Dunkelphase D gleich lang sind, ergibt sich ein besonders einfacher Schaltungsaufbau, zumal sich die Impulse ohne Schwierigkeit von einer entsprechenden Grundfrequenz, beispielsweise eines Oszillators, ableiten lassen. Während der Integrationszeiten TB ist der Schalter S6 gemäß Fig. 5 geschlossen.

Diagramm d zeigt den zeitlichen Verlauf des Integrationswertes I1 bei der Offsetspannung 01 Am Ende der ersten Integrationszeit TA steht der Integrationswert IA an, welcher auch während der nachfolgenden Verzögerungszeit TVB, in welcher keine Integration durchgeführt wird, bestehen bleibt. Während der Dunkelphase D erfolgt für die Integrationszeit TB eine weitere Integration, wobei bedingt durch die Vorzeichenumschaltung des Integrators eine Abintegration erfolgt. Da während der Dunkelphase kein Meßwert ansteht, sondern nur die Offsetspannung 01, wird somit ein entsprechender Wert IB abgezogen. Da erfindungsgemäß die Integrationszeiten TA und TB gleich groß sind, ist der am Ende der Dunkelphase D anstehende Integrationswert nicht mehr durch die Offsetspannung 01 verfälscht. Diese Vorgänge werden insgesamt während vier Perioden T durchgeführt, so daß am Ende der analoge Gesamt-Integrationswert I1 am Ausgang des Integrators ansteht, wobei aufgrund der angegebenen Offset-Kompensation der Gesamt-Integrationswert I1 dem Meßwert U1 entspricht. Das Diagramm e zeigt den zeitlichen Verlauf des Integrationswertes für den Fall, daß dem Meßwert die negative Offsetspannung 02 überlagert ist. Da nunmehr der Betrag aus dem negativen Meßwert U1 und der ebenfalls negativen Offsetspannung 02 kleiner ist als im oben erläuterten Fall, erfolgt auch die Integration während der Integrationszeit TA mit einer geringeren Steigung. Während der Integrationszeit TB in der Dunkelphase D wird nur noch die Offsetspannung 02 integriert, wobei unter Berücksichtigung des Vorzeichens der Integrationswert mit einer entsprechend geringen Steigung anwächst. Am Ende des ersten Taktes ist somit bereits die Offsetspannung kompensiert.

Bei den obigen Erläuterungen wurde davon ausgegangen, daß zumindest während einer Meßspannungsperiode T die Offsetspannung konstant bleibt. Solange diese Voraussetzung gegeben ist, wird also eine gute Kompensation erreicht. Damit dieser Voraussetzung auch in der Praxis Rechnung getragen werden kann, wird die Periodendauer bevorzugt möglichst kurz gewählt. Die durch eine kurze Periodendauer bedingte kurze Integrationszeit zur Mittelwertbildung wird dabei erfindungsgemäß dadurch ausgeglichen, daß eine Anzahl von Perioden nacheinander durchgeführt werden.

Eine praktisch besonders wichtige periodische Störung, die dem Offset überlagert ist und durch die erfindungsgemäßen Maßnahmen kompensiert werden soll, ist der sogenannte Netzbrumm, der mit der Netzfrequenz schwingt und bei der Photometrie sowohl optisch durch Einstreuung von Licht netzbetriebener Lichtquellen als auch durch elektromagnetische Wirkung in der elektronischen Schaltung verursacht sein kann. Diese Störung wird optimal kompensiert, wenn für die Periodendauer T = H + D = TVA + TA + TVB + TB gilt: $T = 2m \cdot T_N$, wobei m eine ganze Zahl und $T_N$ die Periodendauer der Netzfrequenz ist. Wenn eine überlagerte Wechselspannung von 50 Hz bzw. 60 Hz zu kompensieren ist, so beträgt demnach die kürzeste zu wählende Periodendauer T 40 msec. bzw. 33 1/3 msec. Will man beide törfrequenzen mit einer gemeinsamen Periodendauer T eleminieren, so ist die kürzeste geeignete Periodendauer T = 200 msec.

Durch Vergleich der Diagramme d und e wird ohne weiteres ersichtlich, daß unabhängig von dem Vorzeichen der Offsetspannung am Ende der n = vier Perioden jeweils der gleiche Gesamtintegrationswert I1 zur Verfügung steht.

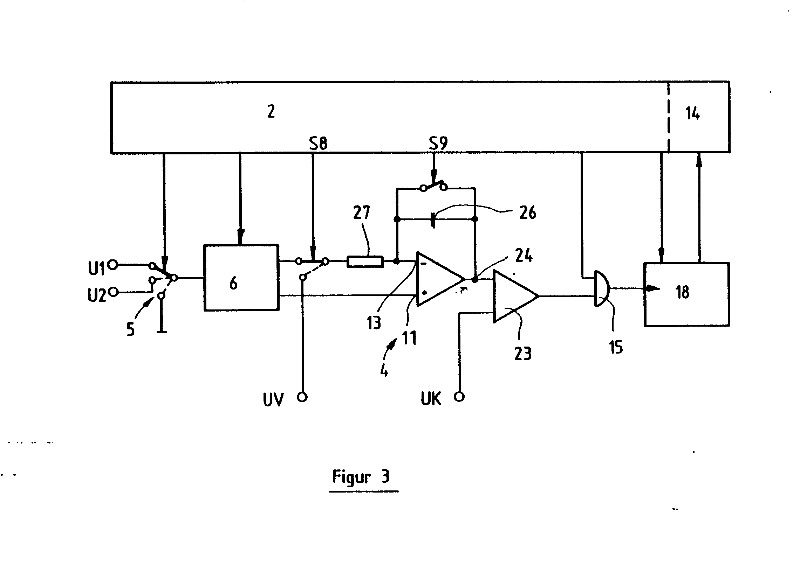

Fig. 3 zeigt ein Blockschaltbild für die Analog-Digital-Wandlung der Meßwerte U1, U2, wobei der Einfachheit halber der Wandler und der Verstärker gemäß Fig. 1 nicht dargestellt sind. Mittels des von der Steuereinrichtung 2 gesteuerten Umschalters 5 können wahlweise die Meßwerte U1 oder U2 mit dem Schalter-Netzwerk 6 verbunden werden. Darüber hinaus kann mittels des Umschalters 5 auch der Eingang des Schalter-Netzwerkes 6 auf Masse gelegt werden. Mit dem Schalter-Netzwerk 6 und dem nachgeschalteten Integrator 4 wird, gesteuert von der Steuereinrichtung 2, die oben erläuterte Nullkompensation und Mittelwertbildung durchgeführt. Es sei daher davon ausgegangen, daß am Ausgang 24 des Integrators 4 der analoge Integrationswert I1 ansteht. Sofern hingegen der Umschalter 5 den Meßwert U2 durchschaltet, steht an dem Ausgang 24 entsprechend ein Integrationswert I2 an. Zur Analog-Digital-Wandlung des jeweiligen Integrationswertes, wobei nachfolgend der Einfachheit halber zunächst nur noch vom Integrationswert I1 gesprochen wird, kann auf den invertierenden Eingang 13 des Integrators 4 nach Betätigung des Abintegrationsschalters S8 eine Abintegrationsspannung UV gegeben werden.

Zwischen Eingang 13 und Ausgang 24 ist der Integrations-Kondensator 26 geschaltet. Dem Integrator 4 ist ein Komparator 23 nachgeschaltet, dessen Ausgang über ein Tor 15 auf einen Zähler 18 geführt ist. An einem weiteren Eingang des Komparators 23 liegt ein Komparatorwert UK in Form einer Gleichspannung an. Gleichzeitig mit Umschalten des Schalters S8 und somit beim Anlegen der Abintegrationsspannung UV wird von der Steuereinrichtung 2 ein Zähltakt über das Tor 15 auf den Zähler gegeben, welcher somit freigegeben wird. Der Zähler wird zweckmäßigerweise zuvor auf Null gesetzt, so daß nunmehr über den Zähltakt der Zähler durchzählt. Aufgrund der anliegenden Abintegrationsspannung UV verringert sich die Spannung am Ausgang 24 des Integrators. Erreicht dann die besagte Spannung den Komparatorwert UK, welcher erfindungsgemäß das entgegengesetzte Vorzeichen wie die genannte Spannung am Ausgang des Integrators aufweist, so sperrt das Tor 15, und es gelangen nunmehr keine weiteren Zähltakte zu dem Zähler 18. Der Zählerstand, d.h. der Digitalwert Z1 entspricht aber nicht direkt dem Meßwert U1, sondern er ist durch verschiedene Störgrößen verfälscht. Genannt seien hier insbesondere die Offsetspannungen des Integrators 4 und des Komparators 23, wobei auch die gesamte Integrationszeit und die Integrationszeitkonstante entsprechend der Kapazität des Kondensators 26 und dem ohmischen Widerstandswert des dem Integrators 4 vorgeschalteten Widerstandes 27 zu berücksichtigen sind.

Der Digitalwert Z1 wird ferner durch die Größe des Komparatorwertes UK und die Größe der Abintegrationsspannung UV beeinflußt. Es bedarf keiner besonderen Erwähnung, daß auch bei der Bildung des Digitalwertes Z2 für den Meßwert U2 entsprechende Störgrößen bzw. Fehler auftreten. Zur Bestimmung eines den genannten Störgrößen und Einflüssen entsprechenden digitalen Nullwertes Z3 wird der Umschalter 5 auf Massepotential gelegt. Die Erfassung der Digitalwerte Z1 bzw. Z2 für die Meßwerte U1 bzw. U2 erfolgt jeweils in gleicher Weise während zweier Integrations- und Digitalisierungsphasen. Die Erfassung des Null-Wertes Z3 erfolgt in einer weiteren, dritten Integrations- und Digitalisierungsphase, welche in der gleichen Weise wie die beiden an deren Phasen mittels der Steuereinrichtung getaktet bzw. gesteuert wird. Der einzige Unterschied besteht darin, daß während der genannten weiteren Integrations- und Digitalisierungsphase mittels des Umschalters 5 das Null-Potential am Eingang des Schaltet bzw. Netzwerkes 6 anliegt. Am Ende jeder Phase werden die Digitalwerte Z1, Z2 sowie der Null-Wert Z3 in die Recheneinheit 14 eingegeben. Mittels der Recheneinheit 14 wird dann in einfacher Weise der Quotient aus den Differenzen von Digitalwert Z2 und Null-Wert Z3 sowie dem Digitalwert Z1 und Null-Wert Z3 gebildet, wobei der genannte Quotient dem gewünschten Meßergebnis aus dem Verhältnis von Meßwert U2 und Referenzwert U1 entspricht.

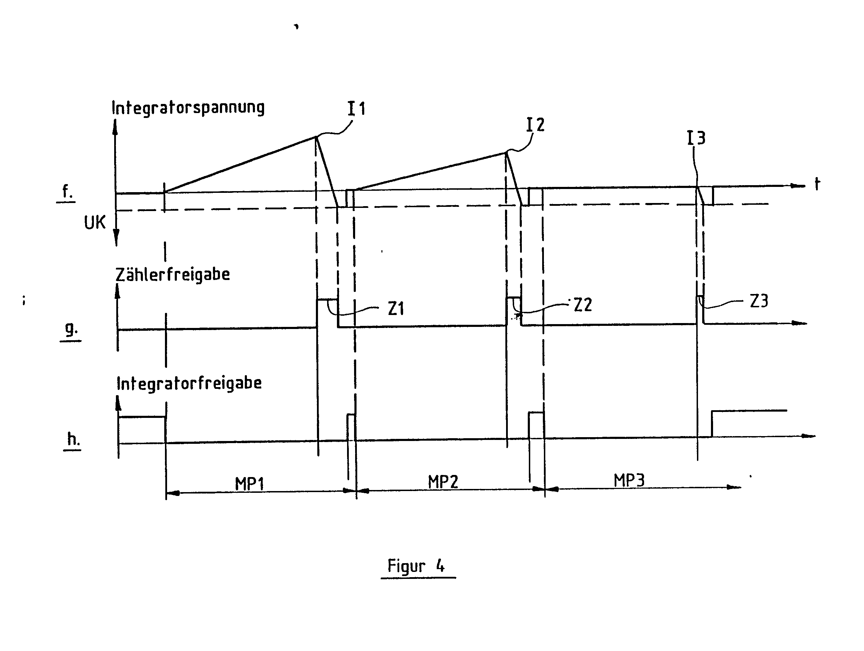

In Fig. 4 ist der zeitliche Verlauf der Integrationswerte sowie die Bildung der entsprechenden Digitalwerte während einer vollständigen Messung über drei Integrations- und Digitalisierungsphasen MP1, MP2 und MP3 dargestellt. Diagramm f zeigt den prinzipiellen Verlauf der Integratorspannung am Ausgang 24 des Integrators. Hierbei ist der Einfachheit halber nach Freigabe des Integrators ein linearer Spannungsanstieg dargestellt. In Wirklichkeit entspricht jedoch der Spannungsanstieg dem anhand von Fig. 2 erläuterten unstetigen Verlauf. Mit Beendigung der oben erläuterten n Meßspannungsperioden steht zunächst der Gesamt-Integrationswert I1 entsprechend dem Referenzwert U1 an. Nachfolgend wird während der Phase MP1 zur Analog-Digital Wandlung die Abintegration durchgeführt, wobei mit Beginn der Abintegration und Anlegen der Abintegrationsspannung UV gleichzeitig gemäß Diagramm g auch die Zählerfreigabe erfolgt. Die Zählerfreigabe wird beendet, wenn die Integratorspannung den negativen Komparatorwert UK erreicht. Während der Zählerfreigabe wird der Digitalwert Z1 gebildet. Anschließend wird gemäß Diagramm h der Integrator auf Null gesetzt, wobei gemäß Fig. 5 der Schalter S9 geschlossen wird. Mit Beginn der zweiten Integrations- und Digitalisierungsphase MP2 erfolgt die Aufintegration des Meßwertes U2, wobei nunmehr in entsprechender Weise der Gesamtintegrationswert I2 gebildet wird. Während der nachfolgenden Abintegration wird wiederum der Zähler freigegeben, und es wird ein dem Integrationswert I2 entsprechender Digitalwert Z2 gebildet. Da der Integrationswert I2 kleiner als der Integrationswert I1 ist, ist auch der Zähler nur für eine kürzere Zeit freigegeben mit der Folge, daß der Zählerstand und der Digitalwert Z2 geringer ist. Erfindungsgemäß wird zur Bestimmung des Null-Wertes die weitere, dritte Meßphase MP3 durchgeführt. Hierbei liegt der Integratoreingang auf Null-Potential, so daß der Integrationswert I3 im wesentlichen gleich Null ist. Aufgrund einer von Null verschiedenen Integratoroffsetspannung kann jedoch auch ein von Null verschiedener Integrationswert I3 entstehen. Durch die Abintegration des Integrationswertes I3 zum Komparatorwert UK und Bildung des Null-Wertes Z3 werden jedoch in einfacher Weise sämtliche Störgrößen, wie Integratoroffsetspannung, Integratoroffsetstrom usw. erfaßt und können digital von dem Meßwert Z2 und dem Referenzwert Z1 subtrahiert werden.

In Fig. 4 erkennt man deutlich, daß die Komparator-Vergleichsspannung UK bevorzugt ungleich Null und entgegengesetzt zum Analog-Signal des Empfängers D1 bzw. D2 gepolt ist. Dadurch wird erreicht, daß man auch dann noch mit Sicherheit eine Schaltflanke erhält, wenn der zu digitalisierende Gesamtintegrationswert extrem klein ist, wie dies insbesondere bei der Integrations- und Digitalisierungsphase MP3 häufig der Fall ist. Bei der Integrations- und Digitalisierungsphase MP3 können darüber hinaus Gesamtintegrationswerte I3 beider Polaritäten entstehen, so daß in einem Fall keine Schaltflanke erzeugt würde, wenn die Vergleichsspannung des Komparators gleich Null gewählt würde. Durch die von Null verschiedene Vergleichsspannung des Komparators ergibt sich ein zu hoher Zählerstand Z1, Z2 und Z3. Da jedoch zur Bildung des Meßergebnisses der Zählerstand Z3 von den Zählerständen Z1 und Z2 jeweils subtrahiert wird und der Fehler der Zählerstände jeweils gleich groß ist, wird dieser Fehler wieder eliminiert.

In Fig. 5 ist ein Prinzip-Schaltbild einer bevorzugten Schaltungsanordnung dargestellt. Die anhand der obigen Figuren bereits erläuterten Bauteile werden hier nicht weiter beschrieben und zur Vermeidung von Wiederholungen wird im Hinblick auf Anordnung und Funktionsweise dieser Bauteile auf die diesbezüglichen Erläuterungen verwiesen. Grundsätzlich werden mit der Steuereinrichtung 2 die Schalter S1 bis S9 betätigt, um die oben bereits eingehend erläuterten Perioden und Phasen im Taktbetrieb durchzusteuern. Mit der Lichtquelle LED liegt der Schalter S1 in Reihe und durch Betätigen des Schalters S1 werden die Hell- und Dunkelphasen H, D gesteuert. Den Empfängern D1, D2 sind Schalter S2, S3 nachgeschaltet, welche dem oben erläuterten Umschalter 5 entsprechen und mit welchen wahlweise der Empfänger D1 oder D2 auf den Wandler 8 durchgeschaltet werden kann. Der Strom-Spannungs-Wandler 8 enthält einen Operationsverstärker 30, welcher mit einem hochohmigen Widerstand 28 beschaltet ist. Eine Verstärkungsdrift kann infolge der Alterung und des Temperaturkooffizienten des Widerstandes 28 eintreten. Aufgrund der erläuterten Umschaltung der Empfänger D1, D2 wird der Einfluß derartiger Verstärkungsdriften weitgehend ausgeschaltet. Es ist nämlich erfindungsgemäß nur eine einzige Meß-, Integrations- und Digitalisierungsschaltung MID vorgesehen, so daß die Verstärkungsdriften für beide Meßwerte U1, U2 während der relativ kurzen Meßdauer von wenigen Sekunden praktisch gleich bleiben.

Änderungen über lange Zeiten werden bevorzugt durch die Bildung des Quotienten zwischen dem Meßwert und dem Referenzwert eliminiert. Dem Wandler 8 ist ferner ein Verstärker 10 nachgeschaltet. Der Verstärkerausgang ist über das Schalternetzwerk mit den Schaltern S4 bis S8 mit dem Integrator 4 verbunden. Mittels des Schalters S4 (Null-Schalter) erfolgt die Umschaltung auf Masse-Potential, um während der weiteren, dritten Integrations- und Digitalisierungsphase MP3 den Null-Wert Z3 zu bestimmen. Während der Phasen MP1, MP2 ist der Schalter S4 in der dargestellten Stellung. Mittels der Schalter S5, S6 wird während der Hell- bzw. Dunkelphase der jeweilige Meßwert oder auch das Massenpotential auf den invertierenden Eingang 13 bzw. den nichtinvertierenden Eingang 11 des Integrators 8 gelegt, so daß während den Hellphasen der jeweilige Meßwert samt Störgröße aufintegriert wird und während der Dunkelphase nur die Störgröße integriert und infolge der Polaritätsumschaltung von dem zuvor erhaltenen Integrationswert vorzeichenrichtig abgezogen wird. Synchron mit den Schaltern S5, S6 arbeitet der weitere Schalter S7, welcher den jeweils nicht beaufschlagten Integratoreingang auf Massepotential legt, so daß die Schalter S5, S6 und S7 ein Umpolschaltwerk bilden. Mittels des Schalters S8 (Abintegrationsschalter) wird zur Durchführung der Analog-Digital-Wandlung mit Beginn der Abintegration der Abintegrationswert UV auf den Integrator gegeben. Dem Integrator 8 bzw. dessen Kondensator 26 ist der Schalter S9 parallel geschaltet, mittels welchem vor Beginn der jeweiligen Meßphase der Integrator 4 auf Null gesetzt wird. Zur Integratorfreigabe wird der Schalter S9 geöffnet. Dem Integrator 4 ist der Komparator 23 und über das Tor 15 der Zähler 18 nachgeschaltet, wobei auf die diesbezüglichen Erläuterungen anhand von Fig. 3 verwiesen wird. Die erfindungsgemäße Anordnung weist einen äußerst einfachen Schaltungsaufbau auf, zumal der Integrator 4 für die Null-Kompensation und Mittelwertbildung ferner für die Analog-Digital-Wandlung und auch für die Bestimmung des Null-Wertes eingesetzt wird. Es sei nochmals besonders hervorgehoben, daß die Anordnung nur einen einzigen Meß- und Integrationskanal aufweist, welcher in einfacher Weise durch die bevorzugt mit einem Mikroprozessor ausgestattete Steuereinrichtung 2 im Taktbetrieb gesteuert wird.

**Patentansprüche**

1. Verfahren zum Erfassen und Auswerten analoger photometrischer Signale (U2) mittels eines Meßgerätes, das eine in Hell-Dunkel-Phasen getaktete Lichtquelle (LED), einen von der Lichtquelle über das Meßobjekt (3) bestrahlten Meßempfänger (D2) und eine an den Meßempfänger anschließbare Meß-Integrations- und Digitalisierungsschaltung (MID) mit einem Integrator (4) enthält, welches Verfahren eine Integrations- und Digitalisierungsphase umfaßt, in der Meßwert (U2) des Empfängers in einer eine Hell- und eine Dunkelphase umfassenden Meßspannungsperiode während mindestens eines Teils der Hellphase (H) und während mindestens eines Teils der Dunkelphase (D) mit dem gleichen Integrator integriert wird, wobei die Teile (TA bzw. TB) der Hellphase (H) und der Dunkelphase (D) gleich groß sind, in der ferner zur Ermittlung des Meßergebnisses der Integrationswert der Dunkelphase (D) von dem der Hellphase (H) abgezogen wird und in der der zur Integration der Meßwerte verwendete Integrator zur Umwandlung des Integrationswertes in ein Digitalsignal nach dem Dual-Slope-Verfahren verwendet wird,

dadurch gekennzeichnet, daß

die Integrations- und Digitalisierungsphase (MP2) folgende Schritte umfaßt:

der Meßwert des Empfängers wird während der Hell- und Dunkelphase der Meßspannungsperiode mit entgegengesetztem Vorzeichen an den Integrator angelegt, so daß der während der Dunkelphase erhaltene analoge integrierte Meßwert von dem während der Hellphase erhaltenen analogen integrierten Meßwert zur Bildung eines analogen Gesamtintegrationswertes (I2) subtrahiert wird,

danach wird der Gesamtintegrationswert (I2) mit Hilfe des gleichen Integrators und einer nachgeschalteten Digitalisierungseinheit digitalisiert und daß eine weitere Integrations- und Digitalisierungsphase (MP3) vorgesehen ist, die in gleicher Weise durchgeführt wird, wobei jedoch statt eines Empfängers ein Null-Signal an den Integrator angelegt ist, um einen weiteren Gesamtintegrationswert (I3) als Null-Wert zu bilden, der in digitalisierter Form (Z3) zur Korrektur des digitalisierten Gesamtintegrationswertes (Z2) benutzt wird.

2. Verfahren nach Anspruch 1, dadurch gekennzeichnet, daß jeweils zu Beginn der Hell- (H) und Dunkelphase (D) der Meßwert des Empfängers während einer Verzögerungszeit (TVA bzw. TVB) nicht integriert wird, wobei die Verzögerungszeiten (TVA bzw. TVB) gleich lang sind.

3. Verfahren nach einem der Ansprüche 1 oder 2 dadurch gekennzeichnet, daß der Meßwert (U2) des Empfängers zur Bildung des analogen Gesamtintegrationswertes zusätzlich zu der Integration der Meßspannungsperiode noch über weitere gleichartige Meßspannungsperioden integriert wird.

4. Verfahren nach einem der vorhergehenden Ansprüche, dadurch gekennzeichnet, daß die Lichtquelle (LED) mit Wechselstrom betrieben wird und die Periodendauer der Meßspannungsperiode (T) ein geradzahliges Vielfaches (2 m) der Periodendauer des Wechselstroms ($T_N$) ist.

5. Verfahren nach einem der vorhergehenden Ansprüche, dadurch gekennzeichnet, daß ein Referenzempfänger von der Lichtquelle über einen Referenzkanal bestrahlt wird, das Signal des Referenzempfängers durch Umschalten alternierend mit dem Signal des Meßempfängers in gleicher Weise wie letzteres Signal ausgewertet wird, und das Meßergebnis aus den digitalisierten Gesamtintegrationswerten (Z1, Z2) des Meß- und des Referenzsignals durch Quotientenbildung abgeleitet wird.

6. Anordnung zur Durchführung des Verfahrens nach Anspruch 1 mit einer Lichtquelle (LED) zur Bestrahlung des zu untersuchenden Objekts (3),

einer Unterbrechungseinrichtung (S1) für die Lichtquelle (LED),

einem Meßempfänger (D2) zum Empfangen der von dem Objekt auf ihn auftreffenden Strahlung und zur Bildung eines Analogsignals,

einer Meß-, Integrations- und Digitalisierungsschaltung (MID), an der das Analogsignal des Meßempfängers (D2) anliegt, um dieses zu messen, zu integrieren und zu digitalisieren, welche Schaltung folgende Bestandteile aufweist:

einen Integrator (4),

einen Abintegrationsschalter (S8), durch den eine Konstantspannung (UV) an den Eingang des Integrators (4) anlegbar ist, deren Polarität derjenigen des Ausgangssignals des Meßempfängers entgegengesetzt ist,

einen Komparator (23) zum Vergleichen der Ausgangsspannung des Integrators (4) mit einer Vergleichsspannung (UK) und

eine Torschaltung (15), durch die Ausgangssignale eines Taktgebers so lange an einen Zähler (18) weitergeleitet wie die Konstantspannung (UV) am Integrator (4) anliegt und die Ausgangsspannung des Integrators (4) größer als die Komparatorspannung (UK) ist,

dadurch gekennzeichnet, daß

ein Umpolungsschaltwerk (S5, S6, S7) zwischen den Meßempfänger und den Integrator (4) geschaltet ist, durch das abwechselnd, synchronisiert mit der Unterbrechungseinrichtung (S1) für die Lichtquelle (LED) das Signal des Empfängers (D2) bei eingeschalteter Lichtquelle (LED) und das Signal des Empfängers (D2) bei unterbrochener Lichtquelle (LED) mit entgegengesetzter Polung mit dem Integrator (4) verbunden wird,

die Meß-, Integrations- und Digitalisierungsschaltung (MID) so ausgebildet ist, daß sie zunächst eine Integration des analogen Ausgangssignals des Meßempfängers über mindestens eine Meßspannungsperiode (T), aus einer Hell- (H) und einer Dunkelphase (D) der Lichtquelle (LED) und anschließend eine Digitalisierung des durch die Integration gebildeten Gesamtintegrationswertes (I2) ausführt,

dem Integrator (4) ein Null-Schalter (S4) vorgeschaltet ist, um den Eingang des Integrators (4) zeitweise mit einem Null-Potential zu verbinden und

eine Recheneinheit (14) vorgesehen ist, durch die das digitalisierte Ausgangssignal der Meß-, Integrations- und Digitalisierungsschaltung (MID) während des Anliegens des Null-Potentials am Integrator (4) von dem digitalisierten Ausgangssignal während des Anliegens eines Empfängers (DI, D2) subtrahiert wird.

7. Anordnung nach Anspruch 6, dadurch gekennzeichnet, daß ein Referenzempfänger (DI) vorgesehen ist, der über einen Umschalter (S2, S3) abwechselnd mit dem Meßempfänger (D2) mit der gleichen Meß-, Integrations- und Digitalisierungsschaltung (MID) verbunden wird.

8. Anordnung nach einem der Ansprüche 6 oder 7, dadurch gekennzeichnet, daß die Empfänger (D1, D2) Photodioden sind und daß die Meß-, Integrations- und Digitalisierungsschaltung (MID) einen Stromspannungswandler (8) einschließt.

9. Anordnung nach Anspruch 8, dadurch gekennzeichnet, daß die Vergleichsspannung (UK) des Komparators (23) ungleich Null ist und eine entgegengesetzte Polarität zum integrierten Analogsignal des Meßempfängers (D2) aufweist.

**Claims**

1. Process for the detection and evaluation of analogous photometric signals (U2) by means of a measurement apparatus which contains a light-dark phase rhythmic light source (LED), a measurement receiver (D2) irradiated from a light source via the measurement object (3) and a measurement integration and digitalisation circuit (MID) with an integrator (4), connectable to the measurement receiver, which process includes an integration and digitalisation phase, in which the measurement value (U2) of the receiver is integrated in a measurement voltage period including a light and a dark phase during at least a part of the light phase (H) and during at least a part of the dark phase (D) with the same integrator, whereby the parts (TA or TB) of the light phase (H) and of the dark phase (D) are equally great, in which, furthermore, for the determination of the measurement result, the integration value of the dark phase (D) is deducted from that of the light phase (H) and is used in the integrator used for the integration of the measurement value for the conversion of the integration value into a digital signal according to the dual slope process, characterised in that the integration and digitalisation phase (MP2) includes the following steps: the measurement value of the receiver is, during the light and dark phase of the measurement voltage period, applied with counter sign digit, to the integrator so that the analogous integrated measurement value obtained during the dark phase is subtracted from the analogous integrated measurement value obtained during the light phase with the formation of an analogous total integration value (I2), thereafter the total integration value (I2) is digitalised with the help of the same integrator and an after-connected digitalisation unit and that a further integration and digitalisation phase (M3) is provided which is carried out in the same way, whereby, however, instead of a receiver, a zero signal is applied to the integrator in order to form a further total integration value (I3) as zero value which, in the digitalised form (Z3), is used for the correction of the digitalised total integration value (Z2).

2. Process according to claim 1, characterised in that, in each case at the beginning of the light (H) and dark phase (D), the measurement value of the receiver is not integrated during a delay period (TVA or TVB), whereby the delay periods (TVA or TVB) are equally long.

3. Process according to one of claims 1 or 2, characterised in that the measurement value (U2) of the receiver, for the formation of the analogous total integration value, is, additionally to the integration of the measurement voltage period, also integrated over further equal measurement voltage periods.

4. Process according to one of the preceding claims, characterised in that the light source (LED) is operated with alternating current and the period length of the measurement voltage period (T) is a whole numbered multiple (2 m) of the period length of the alternating current ($T_N$).

5. Process according to one of the preceding claims, characterised in that a reference receiver is irradiated by the light source via a reference canal, the signal of the reference receiver is, by switching over, evaluated alternatingly with the signal of the measurement receiver in the same way as the last signal and the measurement result is derived from the digitalised total integration values (Z1, Z2) of the measurement and of the reference signal by quotient formation.

6. Arrangement for the carrying out of the process according to claim 1 with a light source (LED) for the irradiation of the object (3) to be investigated, an interruption device (S1) for the light source (LED), a measurement receiver (D2) for the reception of the irradiation from the object impinging upon it and for the formation of an analogous signal, a measurement, integration and digitalisation circuit (MID) to which is applied the analogous signal of the measurement receiver (D2) in order to measure, to integrate and to digitalise this, which circuit has the following components: an integrator (4), an abintegration circuit (S8), by which a constant voltage (UV) can be applied to the input of the integrator (4), the polarity of which is counter to that of the output signal of the measurement receiver, a comparator (23) for the comparison of the output voltage of the integrator (4) with a comparison voltage (UK) and a gate circuit (15) through which the output signals of an impulser are passed on to a counter (18) so long as the constant voltage (UV) is applied to the integrator (4) and the output voltage of the integrator (4) is greater than the comparison voltage (UK), characterised in that a polarity-reversing switchboard (S5, S6, S7) is inserted between the measurement receiver and the integrator (4) through which alternatingly, synchronised with the interruption device (S1) for the light source (LED), the signal of the receiver (D2), in the case of switched-on light source (LED), and the signal of the receiver (D2), in the case of interrupted light source (LED), is connected with counter polarity with the integrator (4), the measurement, integration and digitalisation circuit (MID) is so constructed that it first carries out an integration of the analogous output signals of the measurement receiver over at least one measurement voltage period (T) from a light (H) and a dark phase (D) of the light source (LED) and subsequently a digitalisation of the total

integration value (I2) formed by the integration, a zero circuit (S4) is introduced before the integrator (4) in order to connect the input of the integrator (4) chronologically with a zero potential and a digital unit is provided by which the digitalised output signal of the measurement, integration and digitalisation circuit (MID) is, during the application of the zero potential to the integrator (4), subtracted from the digitalised output signal during the application of a receiver (D1, D2).

7. Arrangement according to claim 6, characterised in that a reference receiver (D1) is provided which, via a change-over switch (S2, S3), is connected alternatingly with the measurement receiver (D2) with the same measurement, integration and digitalisation circuit (MID).

8. Arrangement according to one of claims 6 or 7, characterised in that the receivers (D1, D2) are photodiodes and that the measurement, integration and digitalisation circuit (MID) includes a current voltage converter (8).

9. Arrangement according to claim 8, characterised in that the comparison voltage (UK) of the comparator (23) is not equal to zero and displays a counter polarity to the integrated analogue signal of the measurement receiver (D2).

**Revendications**

1. Procédé pour déterminer et évaluer des signaux photométriques analogiques (U2) au moyen d'un appareil de mesure qui comprend une source lumineuse (LED) rythmée en phases de clarté et d'obscurité, un récepteur de mesures (D2) soumis au rayonnement par l'intermédiaire d'un objet a étudier, et un circuit de mesure, d'intégration et de codification numérique (MID) qui peut être relié au récepteur de mesures et comporte un intégrateur (4), ce procédé comportant une phase d'intégration et de codification numérique dans laquelle la valeur mesurée (U2) du récepteur est intégrée dans une période de tension de mesure comprenant une phase de clarté et une phase d'obscurité, pendant au moins une partie de la phase de clarté (H) et pendant au moins une partie de la phase d'obscurité (D), avec le même intégrateur, les parties (TA ou TB) de la phase de clarté (H) et de la phase d'obscurité (D) étant égales, dans laquelle, pour l'obtention des résultats des mesures, la valeur d'intégration de la phase d'obscurité (D) est soustraite de celle de la phase de clarté (H), et dans laquelle l'intégrateur utilisé pour l'intégration des valeurs mesurées est utilisé pour la conversion de la valeur d'intégration en un signal numérique suivant le procédé à double pente, caractérisé en ce que la phase d'intégration et de codification numérique (MP2) comprend les opérations suivantes, consistant en ce que la valeur mesurée du récepteur est, pendant la phase de clarté et d'obscurité de la période de tension de mesure, appliquée à l'intégrateur avec un signe opposé, de sorte que la valeur mesurée intégrée analogique obtenue pendant la phase d'obscurité est soustraite de la valeur mesureé intégrée analogique obtenue pendant la phase de clarté pour donner une valeur d'intégration globale analogique (I2), qu'ensuite la valeur d'intégration globale (I2) est codifiée en numérique à l'aide du même intégrateur et d'une unité de codification numérique placée en aval, et en ce qu'il comprend une autre phase d'intégration et de codification numérique (MP3) qui se déroule de la même manière, sauf qu'au lieu d'un récepteur, un signal zéro est appliqué à l'intégrateur pour faire d'une autre valeur d'intégration globale (I3) une valeur zéro qui est utilisée sous une forme codifiée en numérique (Z3) pour la correction de la valeur d'intégration globale (Z2) codifiée en numérique.

2. Procédé selon la revendication 1, caractérisé en ce qu'au début de chaque période phase de clarté (H) et d'obscurité (D), la valeur mesurée du récepteur n'est pas intégrée pendant un retard à la montée (TVA ou TVB), les retards à la montée (TVA ou TVB) étant de même longueur.

3. Procédé selon l'une des revendications 1 ou 2, caractérisé en ce que la valeur mesurée (U2) du récepteur donnant la valeur d'intégration globale analogique est intégrée encore sur d'autres périodes de tension de même nature, pour l'intégration de la période de tension de mesure.

4. Procédé selon l'une des revendications 1 à 3, caractérisé en ce que la source lumineuse (LED) fonctionne avec un courant alternatif, et que la durée de la période de tension de mesure (T) est un multiple pair de la durée de la période du courant alternatif ($T_N$).

5. Procédé selon l'une des revendications 1 à 4, caractérisé en ce qu'un récepteur de référence reçoit le rayonnement de la source lumineuse par l'intermédiaire d'un canal de référence, que le signal du récepteur de référence est évalué par échange en alternance avec le signal du récepteur de mesures, de la même manière que le dernier signal, et que le résultat des mesures est déduit par des calculs de quotients des valeurs d'intégration globales (Z1, Z2), codifiées en numérique, du signal de mesure et du signal de référence.

6. Dispositif pour l'application du procédé selon la revendication 1, comprenant une source lumineuse (LED) envoyant un rayonnement sur l'objet (3) à étudier, un dispositif d'interruption (S1) de la source lumineuse (LED), un récepteur de mesures (D2) recevant le rayonnement provenant de l'objet et dirigé sur lui et produisant un signal analogique, un circuit de mesure, d'intégration et de codification numérique (MID), qui reçoit le signal analogique du récepteur de mesures (D2) pour le mesurer, l'intégrer et le codifier en numérique, ce circuit comprenant un intégrateur (4), un commutateur de désintégration (S8), qui peut appliquer à l'entrée de l'intégrateur (4) une tension constante (UV) dont la polarité est opposée à celle du signal de sortie du récepteur de mesures, un comparateur (23) assurant la comparaison de la tension de sortie de l'intégrateur (4) avec la tension de comparaison (UK), et un circuit porte (15) par lequel les signaux de sortie d'une horloge mère sont transmis à un compteur (18) tant que la tension constante (UV) est appliquée à l'intégrateur (4) et que la tension de sortie de l'intégrateur (4) est supérieure à la tension de comparaison (UK), caractérisé en ce qu'un commutateur d'inversion de polarité (S5, S6, S7) est intercalé entre le récepteur de mesures et l'intégrateur (4) et qui relie alternativement à l'intégrateur (4), avec une polarité inverse, en synchronisme avec le dispositif d'interruption (S1) de la source lumineuse (LED), le signal du récepteur (D2) émis quand la source lumineuse (LED) est enclenchée et le signal du récepteur (D2) émis quand la source lumineuse (LED) est interrompue, en ce que le circuit de mesure, d'intégration et de codification numérique (MID) est constitué de telle manière qu'il effectue d'abord une intégration du signal de sortie analogique du récepteur de mesures, sur au moins une période de tension de mesure (T), à partir d'une phase de clarté (H) et d'une phase d'obscurité (D) de la source lumineuse (LED), puis une codification numérique de la valeur d'intégration globale (12) résultant de l'intégration, en ce que l'intégrateur (4) est précédé d'un commutateur zéro (S4) reliant temporairement l'entrée de l'intégrateur (4) au potentiel zéro, et en ce que le dispositif comprend une calculatrice (14) qui soustrait le signal de sortie, codifié en numérique, du circuit de mesure, d'intégration et de codification numérique (MID), émis pendant l'application du potentiel zéro à l'intégrateur (4) du signal de sortie codifié en numérique, émis pendant l'application d'un récepteur (D1, D2).

7. Dispositif selon la revendication 6, caractérisé en ce qu'il comprend un récepteur de référence (D1) qui est relié alternativement, par l'intermédiaire d'un commutateur (S2, S3), au récepteur de mesures (D2) par le même circuit de mesure, d'intégration et de codification numérique (MID).

8. Dispositif selon l'une des revendications 6 ou 7, caractérisé en ce que les récepteurs (D1, D2) sont des photo-diodes, et que le circuit de mesure, d'intégration et de codification numérique (MID) comprend un transformateur de tension de courant (8).

9. Dispositif selon la revendication 8, caractérisé en ce que la tension de comparaison (UK) du comparateur (23) est différente de zéro et a une polarité inverse de celle du signal analogique intégré du récepteur de mesures (D2).

Figur 1

0 075 767

Figur 2

Figur 3

0 075 767

Figur 4

Figur 5

MID  UV  UK

D1  6  26  27  23
LED  28  10  13
D2  30  11  24
15
18

S1  S2  S3  S4  S5  S6  S7  S8  S9

2  14

4

0 075 767